# EUROPEAN PATENT APPLICATION

(11) **EP 2 395 560 A2**
(43) Date of publication of application: **14.12.2011**
(21) Application number: 11168375.1
(22) Date of filing: 01.06.2011
(51) Int. Cl.: H01L 31/048

(54) **Solar cell module**

(30) Priority: 10.06.2010 JP 2010132595
(71) Applicant: Fuji Electric Co., Ltd., Kawasaki-shi 210-9530 (JP)
(72) Inventor: Kogawa, Hiroki, Kawasaki-shi, 210-9530 (JP); Kimijima, Daisuke, Kawasaki-shi, 210-9530 (JP)
(74) Representative: Appelt, Christian W.

(57) **Abstract**

Provided is a solar cell module that has a metal plate integrated therewith and is capable of preventing the occurrence of rust or corrosion even when it is exposed to the elements.

A solar cell module includes a metal plate, a solar cell that is fixed to the metal plate with a sealing member interposed therebetween, and a surface protective film that covers the solar cell. A cutting process is performed on an outer portion of the solar cell, and the cut surface is covered with a non-solvent-based resin material. The solar cell module has a rectangular shape and the corners thereof are cut in an L-shape. Protruding piece portions formed by the cut-out portions are bent such that the solar cell module has a box shape.

## Description

### BACKGROUND OF THE INVENTION

### 1. Field of the Invention

The present invention relates to a solar cell module in which a solar cell is fixed to a metal plate.

### 2. Description of the Related Art

A solar cell module has been known which includes a solar cell formed by laminating, for example, a rear electrode layer, a photoelectric conversion layer, and a transparent electrode layer on a film substrate. In the solar cell module, the solar cell is provided between the surface protective film and the metal plate with a sealing member interposed therebetween and is fixed and sealed. The solar cell module having the metal plate integrated therewith is attached to the roof of the house, the rooftop of a building, or the wall of a structure, or is installed on the ground, and is used as a solar power generator.

As the metal plate, a steel plate subjected to a surface treatment is generally used since it is relatively inexpensive. As the sealing member, a hot-melt resin film made of, for example, ethylene-vinyl acetate copolymer (hereinafter, referred to as EVA) is generally used. As the surface protective film, for example, a fluorine resin-based film made of a material with high moisture resistance, high weather resistance, and high transparency is used. The sealing member is interposed between the solar cell and the metal plate and between the solar cell and the surface protective film, and the laminate is heated in vacuum to seal the solar cell, thereby forming a solar cell module having the metal plate integrated therewith.

As the solar cell module having the metal plate integrated therewith, Japanese Patent Application Laid-Open No. 2005-123370 discloses a solar cell module having a power converter integrated therewith. The solar cell module includes at least one photovoltaic element and one power conversion substrate. A metal plate is integrally formed on at least a portion of a non-light receiving surface of the solar cell module, and a portion of the metal plate is bent in a rectangular U-shape. The power conversion substrate is arranged in the rectangular U-shaped portion, and an electrode connection member of the photovoltaic element is electrically connected to the power conversion substrate. The power conversion substrate is sealed in the rectangular U-shaped portion by a resin.

In the solar cell module having the metal plate integrated therewith, the metal plate is bent in order to improve strength, or it is formed in a shape suitable for the installation of the solar cell module. In the bending process, a portion of the metal plate is cut out.

However, in the structure in which the metal plate is cut out, even when a surface treatment, such as an antirust treatment, is performed on the metal plate, the cut surface is exposed to the elements and rust or corrosion occurs in the cut surface. As a result, the appearance of the solar cell module deteriorates, or the strength of the solar cell module is reduced.

### SUMMARY OF THE INVENTION

An object of the invention is to provide a solar cell module that has a metal plate integrated therewith and is capable of preventing the occurrence of rust or corrosion even when it is exposed to the elements.

In order to achieve the object, according to an aspect of the invention, there is a provided a solar cell module including a metal plate, a solar cell that is covered with an insulating sealing member, and a surface protective film. The solar cell is provided between the metal plate and the surface protective film with the sealing member interposed therebetween such that it is sealed. At least a portion of the solar cell module that is outside the solar cell and includes the metal plate is cut, and a cut surface is coated with a non-solvent-based resin material.

According to the above-mentioned aspect of the invention, the cut surface of the metal plate is coated with a resin material. Therefore, even when the solar cell module is exposed to the elements, it is possible to prevent the occurrence of rust and corrosion in the cut surface, maintain the appearance of the solar cell module, and improve durability. In addition, since the non-solvent-based resin material is used, it is possible to prevent peeling-off at the interface between the metal plate and the sealing member interposed between the solar cell and the metal plate.

In the solar cell module according to the above-mentioned aspect, the cut surface may be desirable to be coated with a non-solvent-based resin material selected from a silicon-based resin, an epoxy-based resin, a urethane-based resin, and an acryl-based resin.

In the solar cell module according to the above-mentioned aspect, the metal plate may be a steel plate subjected to a surface treatment. According to this structure, it is advantageous in that the metal plate has relatively high rigidity and a low cost.

In the solar cell module according to the above-mentioned aspect, the solar cell module may have a rectangular shape before the cutting process. The corners of the solar cell module may be cut in an L-shape. Protruding piece portions formed by the cut-out portions may be bent such that the solar cell module has a box shape. Since the solar cell module has a box shape, the strength of the solar cell module is improved and it is easy for the solar cell module to be installed on the roof, rooftop, or wall of the building. However, the invention is not limited to the shape.

### BRIEF DESCRIPTION OF THE DRAWINGS

Fig. 1 is a perspective view illustrating a solar cell module according to an embodiment of the invention;
Fig. 2 is a partial enlarged cross-sectional view illustrating the layer structure of the solar cell module; and
Figs. 3A to 3E are diagrams illustrating a process of manufacturing the solar cell module.

### DESCRIPTION OF THE PREFERRED EMBODIMENTS

Hereinafter, a solar cell module according to an embodiment of the invention will be described with reference to the accompanying drawings.

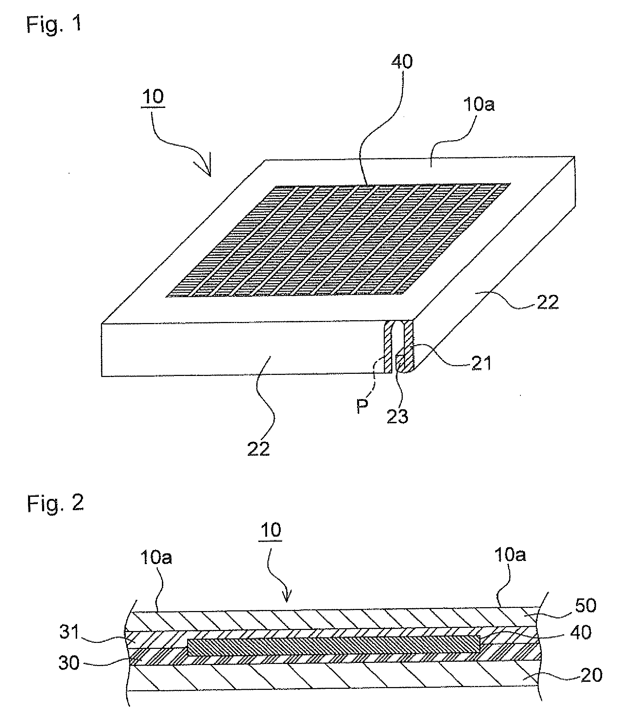

As shown in Fig. 2, a solar cell module 10 includes a metal plate 20, a solar cell 40 that is covered with sealing members 30 and 31, and a protective film 50. Specifically, the solar cell 40 is provided on the metal plate 20 with the sealing member 30 interposed therebetween and the protective film 50 is provided on the solar cell 40 with the sealing member 31 interposed therebetween. These components are laminated or bonded into an integrated structure by an adhesive.
An outer portion 10a in which the metal plate 20, the sealing members 30 and 31, and the protective film 50 are bonded to each other is provided in a periphery (outside) portion of the solar cell module 10 in which the solar cell 40 is not provided.

A steel plate, an aluminum plate, or a stainless plate is given as an example of the metal plate 20. It is preferable to use a steel plate subjected to a surface treatment, such as a hot-dipped steel plate, a polyester resin coated steel plate, an acrylic resin coated steel plate, or a fluorine resin coated galvanized steel plate, in terms of a relatively low cost and high rigidity. Since the corrosion problem of a cross section which is cut by a post-process is noticeable in these steel plates, the invention is effective in the steel plates.

The structure of the solar cell 40 is not particularly limited, but the solar cell 40 includes a substrate which is a flexible film made of, for example, a polyimide resin or a polyester resin, a glass plate, or a stainless plate and a photoelectric conversion element including, for example, a rear electrode layer, a photoelectric conversion layer, and a transparent electrode layer formed on the substrate.

For example, a film made of ethylene-vinyl acetate copolymer (hereinafter, referred to as EVA) or a resin material, such as an epoxy resin, a urethane resin, a silicon resin, an acrylic resin, a fluorine resin, or polyisobutylene, is preferably used as the sealing members 30 and 31.

The protective film 50 is, for example, a transparent film with high weather resistance which is made of, for example, polytetrafluoroethylene-ethylene copolymer, a vinylidene fluoride resin, a chlorotrifluoroethylene resin, an acrylic resin, a chlorotrifluoroethylene resin coated acrylic resin, or a polyester resin. The protective film 50 may be a film including a reinforcing material such as glass fiber.

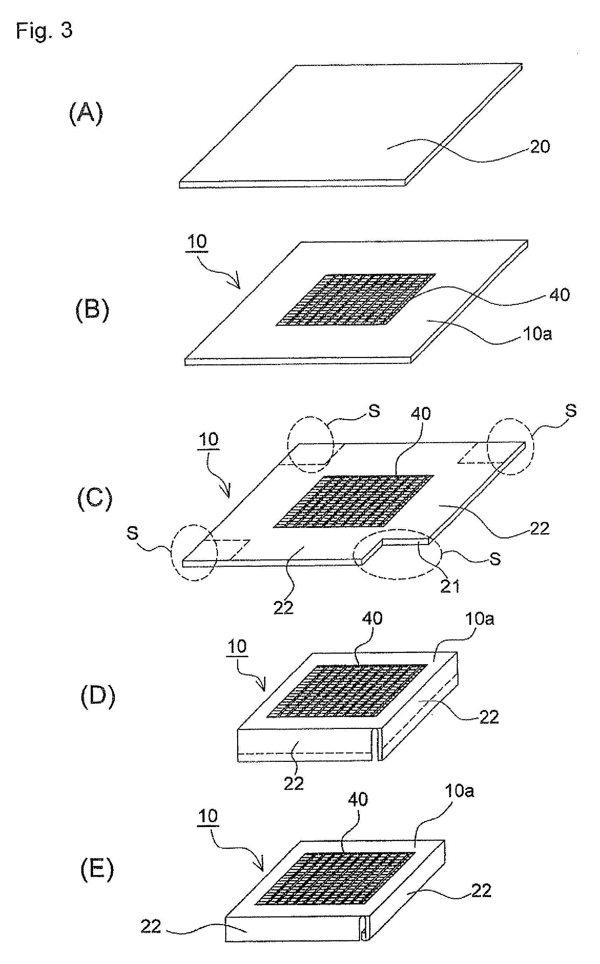

Figs. 3A to 3E show a process of manufacturing the solar cell module 10.

That is, first, as shown in Fig. 3A, the metal plate 20 that is made of the above-mentioned material and has a substantially rectangular shape is prepared. Then, as shown in Fig. 2, the solar cell 40 is formed on the metal plate 20 with a sealing resin film (sealing member 30) interposed therebetween and the protective film 50 is formed on the solar cell 40 with a sealing resin film (sealing member 31) interposed therebetween. Then, the laminate is heated into a module in vacuum by a vacuum heat treatment, or the components are bonded into a module by an adhesive.

As shown in Fig. 3B, the solar cell module 10 in which the solar cell 40 is bonded to the metal plate 20 with the sealing member 30 interposed therebetween and the protective film 50 is formed on the solar cell 40 with the sealing member 31 interposed therebetween is obtained.

Then, as shown in Fig. 3C, four corners S of the outer portion 10a of the solar cell 40 in the solar cell module 10 shown in Fig. 3B are cut in an L-shape to form cut-out portions 21.

As shown in Fig. 3D, protruding piece portions 22 that are formed at each side by the cut-out portions 21 are bent in the same direction such that the solar cell module 10 has a box shape.

Then, the protruding piece portions 22 are bent along a dotted line into a shape shown in Fig. 3E.

In this way, as shown in Fig. 1, the protruding piece portions 22 formed at four sides of the solar cell module 10 are bent twice and bent portions 23 are formed inside the solar cell module 10. Therefore, the solar cell module 10 having a box shape as a whole is obtained. The bent structure makes it possible to improve the overall rigidity or strength of the solar cell module 10 having a box shape. As a result, the solar cell module 10 can have sufficient strength even when it is installed on, for example, the roof, rooftop, and wall of the house.

In the solar cell module 10, the cut surface of the metal plate 20 is formed by the cut-out portions 21 formed in the process shown in Fig. 3C. In the invention, an anti-corrosion treatment is performed to coat the cut surface of the cut-out portion 21 with a resin material P.

When a solvent-based resin material is used as the resin material P, the metal plate 10 and the sealing member 30 are likely to peel off at the interface therebetween. Therefore, a non-solvent-based resin material is used as the resin material P. It is preferable that a non-solvent-based resin material selected from a silicon-based resin, an epoxy-based resin, a urethane-based resin, and an acryl-based resin be used as the resin material P. In particular, a silicon-based resin is preferable.

It is preferable to use the resin material P with a viscosity of 0.5 to 20 [Pa·s] at 23±2°C, which is measured by a Brookfield rotary viscometer, in terms of workability.

When a transparent resin material P is used, it is difficult to know the coating state of the resin material. Therefore, it is preferable to use a black or white resin material P.

The method of bending the metal material is not limited to that according to this embodiment, but various kinds of bending methods may be used according to the installation position of the solar cell module.

### [Examples]

### (Example 1)

A solar cell module was manufactured by the manufacturing process shown in Figs. 3A to 3E.

Four corners of an outer portion of a solar cell of the solar cell module were cut in an L-shape and the protruding piece portions 22 formed by the cutting were bent by the above-mentioned method to obtain a box-shaped solar cell module 10.

A non-solvent-based resin (white sealing material), which was a silicon-based resin, was coated on the cut surface of the cut-out portion 21 of the solar cell module 10 by a brush for coating, thereby covering the cut surface with a resin film.

### (Comparative example 1)

In Comparative example 1, a solar cell module was manufactured by the same method as that in Example 1 except that the cut surface of the cut-out portion 21 of the solar cell module 10 was not coated with a resin, but was exposed.

### (Comparative example 2)

In Comparative example 2, a solar cell module was manufactured by the same method as that in Example 1 except that, instead of the non-solvent-based resin, a solvent-based resin, which was a silicon-acryl-based resin, was coated by a brush for coating to cover the cut surface with a resin film.

A Cyclic Corrosion Test (CCT), a high temperature and high humidity test, and an outdoor exposure test were performed on each of the solar cell modules according to Example 1, Comparative example 1, and Comparative example 2.

In the CCT, a process of spraying 5% Nad salt water onto the solar cell module at a temperature of 35+1°C for two hours, drying the salt water at a temperature of 80±1°C, and leaving the solar cell module for two hours under the conditions of a temperature of 50+1°C and a humidity of 95% Rh or more was repeatedly performed 180 times, and the visual examination was performed on the solar cell module.

In the high temperature and high humidity test, the solar cell module was left for 3000 hours under the conditions of a temperature of 85°C and a humidity of 95% Rh, and the visual examination was performed on the solar cell module per 300 hours.

In the outdoor exposure test, the solar cell module was left outdoors for 90 days and the visual examination was performed on the solar cell module.

The examination result was evaluated.

The examination result is shown in Table 1, in which O indicates that there is no peeling-off and there is no rust, 6 indicates that there is no peeling-off and there is rust, A indicates that there is peeling-off and there is no rust, and x indicates there is peeling-off and there is rust.

**[Table 1]**

| | Example 1 Non-solvent-based resin is coated | Comparative example 1 No treatment is performed on cut surface | Comparative example 1 Solvent-based resin is coated |
|---|---|---|---|
| CCT (spray and dry salt water) | ○ | × | × |
| igh temperature and high humidity test | ○ | △ | ▲ |
| Outdoor exposure test | ○ | △ | ▲ |

As can be seen from the result of Table 1, in Example 1 in which a non-solvent-based resin was coated, rust and peeling-off did not occur in various environments and durability was high. In Comparative example 1 in which no treatment was performed on the cut surface, rust resistance was low and peeling-off occurred under the condition that salt water was sprayed. In Comparative example 2 in which a solvent-based resin was coated, peeling-off occurred in any condition and rust occurred under the condition that salt water was sprayed.
According to the above-mentioned aspect of the invention, it is possible to prevent the occurrence of rust and corrosion in the cut surface, maintain the outward appearance of the solar cell module, and improve durability.

## Claims

1. A solar cell module comprising:
a metal plate;
a solar cell that is covered with an insulating sealing member; and
a surface protective film,
wherein the solar cell is provided between the metal plate and the surface protective film with the sealing member interposed therebetween such that it is sealed, and
at least a portion of the solar cell module that is outside the solar cell and includes the metal plate is cut, and a cut surface is coated with a non-solvent-based resin material.

2. The solar cell module according to claim 1, wherein the cut surface is coated with a non-solvent-based resin material selected from a silicon-based resin, an epoxy-based resin, a urethane-based resin, and an acryl-based resin.

3. The solar cell module according to claim 1 or 2, wherein the metal plate is a steel plate subjected to a surface treatment.

4. The solar cell module according to any one of claims 1 to 3,
wherein the solar cell module has a rectangular shape before the cutting process,
the corners of the solar cell module are cut in an L-shape, and
protruding piece portions formed by the cut-out portions are bent such that the solar cell module has a box shape.
